# EUROPEAN PATENT APPLICATION

(11) **EP 4 708 131 A1**
(43) Date of publication of application: **11.03.2026**
(21) Application number: 25196962.2
(22) Date of filing: 20.08.2025
(51) Int. Cl.: G06K 19/07

(54) **CLOCKLESS SELF TUNING RFID TAG**

(30) Priority: 10.09.2024 US 202418830224
(71) Applicant: NXP B.V., 5656 AG Eindhoven (NL)
(72) Inventor: De La Cruz Marin, Jorge Vicente, 5656AG Eindhoven (NL); de Meulmeester, Jacobus, 5656AG Eindhoven (NL); Stadlmair, Rainer, 5656AG Eindhoven (NL)
(74) Representative: Krott, Michel

(57) **Abstract**

A self-tuning device and related method includes a first voltage indicative of a first magnitude of an input signal to an antenna stored in a first capacitor when a variable capacitor bank coupled to the antenna is in a first configuration and a second voltage indicative of a second magnitude of the input signal when the variable capacitor bank is in a second configuration are compared. A first output signal based on the comparison is used to determine, the first configuration of the variable capacitor bank results in an optimized configuration of the variable capacitor bank. The variable capacitor bank is configured in the first configuration.

## Description

### FIELD OF THE INVENTION

The present invention generally relates to Radio Frequency Identification (RFID) tag devices and, more specifically, to a system and method for tuning an antenna of an RFID tag to optimize power signal generated by the RFID tag.

### BACKGROUND

Radio Frequency Identification (RFID) refers to a wireless system comprised of two components: tags and readers. The reader is a device that has one or more antennas that emit radio waves and receive signals back from the RFID tag. Tags, which use radio waves to communicate their identity and other information to nearby readers, can be passive or active. Passive RFID tags can be powered by the reader and do not have a battery. Active RFID tags can be powered by batteries. Near Field Communication (NFC) is a wireless communication technology that acts over short distances for two-way communication. The use of NFC tags is growing in several markets, including the medical, consumer, retail, industrial, automotive, and smart grid markets. NFC is a type of RFID technology. Due to internal or external factors such as distance from the other device or tag, nearby objects, etc. the tag's antenna needs to be tuned to balance the antenna's impedance to optimize the received signal strength before a data read cycle starts.

### SUMMARY

This Summary section is neither intended to be, nor should be, construed as being representative of the full extent and scope of the present disclosure. Additional benefits, features and embodiments of the present disclosure are set forth in the attached figures and in the description hereinbelow, and as described by the claims. Accordingly, it should be understood that this Summary section may not contain all of the aspects and embodiments claimed herein.

Additionally, the disclosure herein is not meant to be limiting or restrictive in any manner. Moreover, the present disclosure is intended to provide an understanding to those of ordinary skill in the art of one or more representative embodiments supporting the claims. Thus, it is important that the claims be regarded as having a scope including constructions of various features of the present disclosure insofar as they do not depart from the scope of the methods and apparatuses consistent with the present disclosure (including the originally filed claims). Moreover, the present disclosure is intended to encompass and include obvious improvements and modifications of the present disclosure.

In some aspects, the techniques described herein relate to a radio frequency identification (RFID) tag, including: an antenna configured to receive an input signal; a variable capacitor bank electrically coupled to the antenna; and a self-tuning circuit coupled with the antenna, wherein the self-tuning circuit is configured to modify a capacitance of the variable capacitor bank to optimize a signal strength of the input signal according to a self-tuning algorithm, wherein the self-tuning circuit does not include a clock source and the self-tuning circuit includes: a first comparator, including: a first capacitor configured to store a first voltage indicative of a first magnitude of the input signal when the variable capacitor bank is in a first configuration, and a first comparator device having a first input terminal and a second input terminal, wherein the first input terminal is configured to receive a second voltage indicative of a second magnitude of the input signal when the variable capacitor bank is in a second configuration and the second input terminal is configured to receive the first voltage from the first capacitor, wherein the first comparator device is configured to generate a first output signal based on a difference between the first voltage and the second voltage; and a controller configured to determine, using the first output signal of the first comparator device, that the first configuration of the variable capacitor bank results in an optimized configuration of the variable capacitor bank compared to the second configuration and to configure the variable capacitor bank in the first configuration.

In some aspects, the techniques described herein relate to a device, including: a first comparator, including: a first capacitor configured to store a first voltage indicative of a first magnitude of an input signal when a variable capacitor bank coupled to an antenna is in a first configuration, and a first comparator device having a first input terminal and a second input terminal, wherein the first input terminal is configured to receive a second voltage indicative of a second magnitude of the input signal when the variable capacitor bank is in a second configuration and the second input terminal is configured to receive the first voltage from the first capacitor, wherein the first comparator device is configured to generate a first output signal based on a difference between the first voltage and the second voltage; and a controller configured to determine a configuration of a variable capacitor bank using the first output signal of the first comparator device.

In some aspects, the techniques described herein relate to a method of executing a self-tuning algorithm for a radio frequency identification tag, including: storing a first voltage indicative of a first magnitude of an input signal to an antenna in a first capacitor when a variable capacitor bank coupled to the antenna is in a first configuration; providing a second voltage indicative of a second magnitude of the input signal when the variable capacitor bank is in a second configuration to a first input terminal of a first comparator device; providing the first voltage from the first capacitor to a second input terminal of the first comparator device, wherein the first comparator device is configured to generate a first output signal based on a difference between the first voltage and the second voltage; determining, using the first output signal of the first comparator device, that the first configuration of the variable capacitor bank results in an optimized configuration of the variable capacitor bank compared to the second configuration; and configuring the variable capacitor bank in the first configuration.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 shows a schematic of an embodiment of an RFID tag that includes an antenna.
FIG. 2 is a block diagram depicting functional components of an RFID tag self-tuning system of the present disclosure.
FIG. 3 is a flowchart depicting a method that may be implemented by an RFID tag controller to optimize the configuration of a capacitor bank coupled to the tag's antenna to optimize power coupling from an ambient electrical field into the antenna.
FIG. 4 is a circuit diagram depicting an example RFID tag self-tuning circuit configured in accordance with the present disclosure.
FIG. 5 is a flowchart depicting a method that may be implemented by a controller of the RFID tag self-tuning circuit of FIG. 4 to implement a self-tuning algorithm to determine an optimal configuration of the RFID tag's antenna.
FIG. 6 is a flow chart depicting an example method implemented by an RFID tag controller to perform a tag initiation process.
FIG. 7 is a flow chart depicting an example method implemented by a controller of an RFID to perform this signal acquisition.
FIG. 8 is a flow chart depicting an example method implemented by a controller of an RFID tag to perform a signal comparison step.

### DETAILED DESCRIPTION

The present invention generally relates to Radio Frequency Identification (RFID) tag devices and, more specifically, to a system and method for tuning an antenna of an RFID tag to optimize power signal generated by the RFID tag.

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment", "an embodiment", "one example", or similar language means that a particular feature, structure, or characteristic described in connection with the indicated embodiment is included in at least one embodiment of the present invention. Thus, the phrases "in one embodiment", "in an embodiment", and similar language throughout this specification may, but do not necessarily, all refer to the same embodiment.

Radio frequency identification (RFID) tags can store a range of information from one serial number to several pages of data. As an example, near field communications (NFC) is a technology based on RFID technology

In an active peer-to-peer (P2P) mode of operation, two active RFID tag devices can create a wireless communication channel between them. Of the two devices, the active device, with an external power supply, can power the passive device with the electromagnetic field being emitted by the active device. In typical applications, NFC passive devices are used because the passive NFC device can be a simple tag whose electronic circuits can be electrically powered by the electromagnetic field emitted by the active device.

As observed by the passive device, the strength of the received electromagnetic field (and, therefore, the field's ability to power the passive device) may be dependent on the distance between the passive and active devices as well as external factors such as nearby objects, other ambient electric fields, etc. Therefore, in some examples, a passive device may be capable of tuning its antenna to improve the antenna's ability to absorb energy from the active device's emitted electrical field, thereby improving power transfer to the passive device. In various approach, this may involve the passive device being configured to include a switchable capacitor bank coupled to the passive device's antenna. By adjusting the capacitance value of the switchable capacitor bank, the passive device can "tune" its antenna to improve power transfer. Specifically, the input impedance of the receiver antenna of the passive device can be adjusted or tuned by changing the capacitor value of the capacitor bank to optimize the signal strength of the input signal to the passive device.

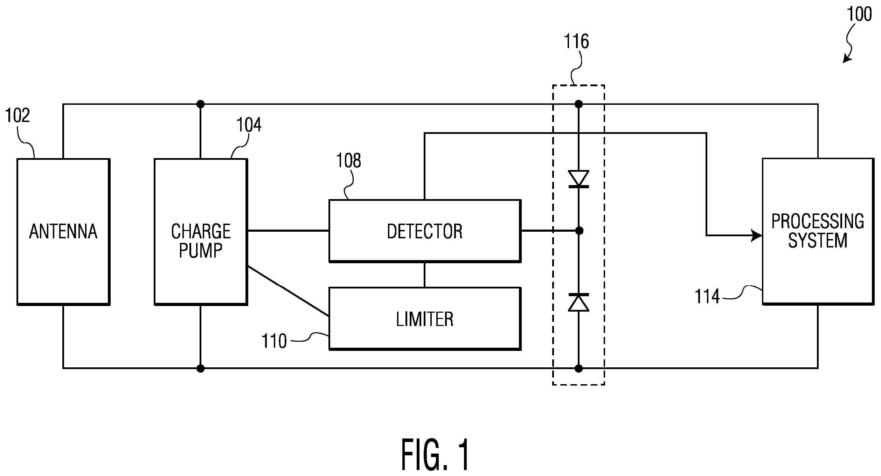

FIG. 1 shows a schematic of an embodiment of an RFID tag 100 that includes an antenna 102. The antenna 102 may be a wire coil type antenna. The antenna 102 absorbs energy from ambient electromagnetic fields and provides that energy as an input AC signal to a charge pump (e.g., AC to DC converter) 104 which accumulates the electrical energy received from antenna 102 to ultimately generate a useable output DC voltage.

Typically, the energy absorbed by antenna 102 is of the form of a continuous wave with a predefined frequency (e.g., 13.56 MHz). The charge pump 104 receives that AC signal and converts the AC signal to a DC voltage. The charge pump 104 may use diodes and charging/discharging capacitors to change the input AC signal to higher voltage DC signal. While the input AC signal is positive, current flows through diodes and charges capacitors and during the negative cycle, no current flows through diodes and capacitors discharge.

The charge pump 104 may include or may be coupled with a limiter circuit 110. The limiter circuit 110 caps the output of the charge pump 104 to a predefine voltage. The limiter circuit 110 can operate to protect components of RFID tag 100 from electrical spikes that may result from electrostatic events or a received signal strength that is too high for safe operations of RFID tag 100.

RFID tag 100 includes an envelope detector 116 to provide a DC output from the envelope of the input signal received at the antenna 102. An envelope detector (or peak detector) is an electronic circuit that takes a (relatively) high-frequency amplitude modulated signal as input and provides an output which is the envelope of the original signal.

RFID tag 100 includes processing system 114 that is configured to optimize the input signal strength based on a signal from the detector 108. The signal from the detector 108 may include information about the changes in the signal strength of the input AC signals received via the antenna 102 to enable the processing system 114 to optimize the input signal strength, in one example, through changing the input impedance of the antenna 102 of RFID tag 100. In that case, processing system 114 may configured to modify the configuration of an adjustable capacitor bank that is coupled to antenna 102 to optimize power transfer into antenna 102.

In RFID tag 100, processing system 114 is tasked with configuring antenna 102 and any connected adjustable capacitor bank to optimize power transfer from any ambient electromagnetic field into antenna 102 for use by RFID tag 100. In conventional RFID tags, any such processing system 114 can operate as a clocked final state machine (FSM) to control the overall operation of RFID tag 100.

A conventional operation of processing system 114 to control the configuration of antenna 102 generally requires the implementation of a FSM to cause RFID tag 100 components to detect a power level of a signal currently being received at antenna 102 of RFID tag 100, and then, based upon an analysis of that signal magnitude, the configuration of a tuneable input impedance and a circuit that adjusts the input impedance of antenna 102 based on the signal magnitude measurement. The functions are typically provided in a processing system 114 by standard synchronous digital logic circuits. Such circuits require an oscillator operating at a specific frequency to function as a system clock that controls and enable the operation of the digital logic system. Such oscillators and circuits require non-negligible amounts of electrical power to operate and, as such, represent substantial power draws of a conventional RFID tag 100, which can negatively affect the performance of such a system.

To remedy these problems with conventional tuning approaches (i.e., implemented in digital logic), the present disclosure provides an alternative approach to antenna tuning in an RFID tag that utilizes analog logic circuits to execute a tuning algorithm. In embodiments, the present disclosure provides a clockless self-tuning circuit for RFID device antenna tuning that provides a non-clock driven approach to antenna tuning, which can result in optimized power usage within the RFID tag device. Specifically, the present approach may reduce the power consumption of components required to provide clock signals and other digital logic control circuits and the risk that such oscillators may fail to power-up in the event of relatively low-magnitude ambient electromagnetic fields.

In the present disclosure, a system is presented in which asynchronous signals, derived from the signal received at the RFID tag antenna, are utilized to operate the self-tuning algorithm and components. In particular, aspects of the self-tuning system, without use of an input clock signal, is configured to detect changes in the magnitude of the signal received by the RFID tag's antenna that results from changes in antenna impedance as a mechanism by which to optimize the antenna configuration with reduced power consumption as compared to conventional approaches.

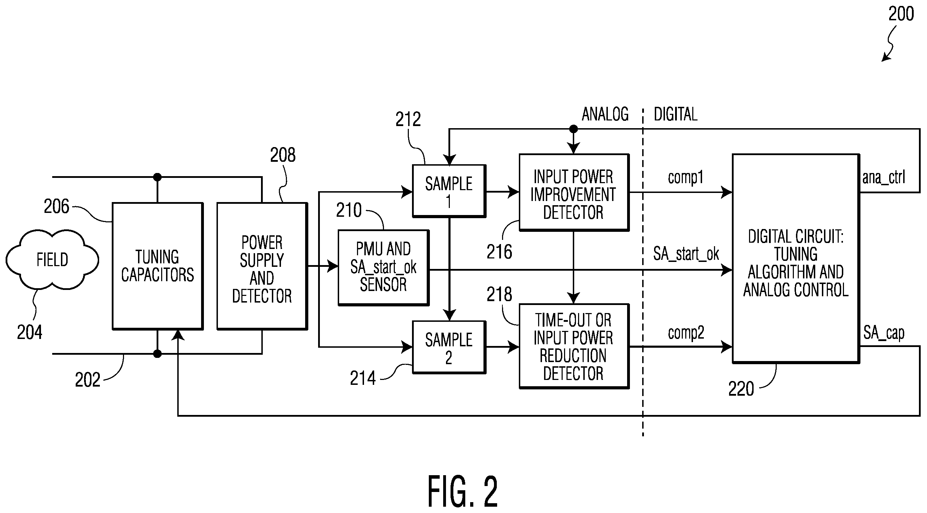

FIG. 2 is a block diagram depicting functional components of an RFID tag self-tuning system 200 of the present disclosure. RFID tag self-tuning system 200 includes antenna 202, which is present within an ambient electrical field 204. Antenna 202 is connected to capacitor bank 206. Tuning capacitor bank 206 is a component with a capacitance value that can be adjusted by either electrically connecting or disconnecting different combinations of individual capacitors that are within capacitor bank 206. Typically, capacitor bank 206 is implemented by a collection of capacitors and switches enabling different combinations of capacitors (which may each have the same capacitance value or different capacitance values) to be electrically connected within capacitor bank 206 to adjust the inductance thereof and the impedance of the connected antenna 202.

Power supply and detector 208 is coupled to antenna 202 and is configured to receive the electrical signal from antenna 202 generated by ambient electrical field 204. Power supply and detector 208 is configured to use that electrical signal to provide electrical power (e.g., via use of a charge pump) to the other components of self-tuning system 200, as described herein, as well as output a measurement value indicative of the magnitude of the electrical signal received from antenna 202.

Power management unit (PMU) 210 is configured to control whether RFID tag self-tuning system 200 is operational based upon the magnitude of the power supply signal being received from power supply and detector 208. In one example mode of operation, PMU 210 is a control system configured to maintain various components of self-tuning system (e.g., in both the analog and digital domains) under a reset state (i.e., state "0") until the signal being received from power supply and detector 208 indicates an adequate power supply signal is presented to enable all self-tuning system 200 power-up conditions are reached. Once those conditions are met, PMU 210 is configured to leave the reset condition and assert an SA_start_ok signal enabling self-tuning system 200 to transition into its first operative state (i.e., state "1") as detailed below.

Self-tuning system 200 includes two signal sampling circuits, sampler 212 and sampler 214. The operation of these sampling circuits is described in more detail below, however, in general sampler 212 and sampler 214 are configured to acquire proportional samples of the power supply signal being generated by power supply and detector 208. The output of sampler 212, which is equivalent to a magnitude of the power supply signal being received from power supply and detector 208 is provided as an input to input power improvement detector 216. Input power improvement detector 216 is configured to determine whether the current magnitude of the sampled signal taken with capacitor bank 206 in a current configured to greater than the magnitude of the sample signal with capacitor bank 206 in a different configuration. This comparison, therefore, allows self-tuning circuit 200 to identify which configuration of capacitor bank 206 provided a greater magnitude power signal generated by power supply and detector 208. By iteratively testing different capacitor bank 206 configurations in this manner, self-tuning system 200 can determine the configuration of capacitor bank 206 that optimizes the ability of antenna 202 to absorb electrical energy from ambient electrical field 204.

Sampler 214 is configured similarly to sampler 212 in that sampler 214 is configured to measure a magnitude of the power supply signal received from power supply and detector 208. The output of sampler 214 is provided to input power reduction detector 218. Input power reduction detector 218 is configured to determine whether the current magnitude of the sampled signal taken with capacitor bank 206 in a current configuration is less than or equal to the magnitude of the sample signal with capacitor bank 206 in a different configuration. When the output of input power reduction detector 218 goes to a high value, indicating that the coupling between antenna 202 and ambient electrical field 204 has become less effective, that high value may be utilized, as described herein to termination the self-tuning operation as further modifications to capacitor bank 206 will likely further decrease the efficiency of antenna 202 indicating that the optimum configuration has already been identified.

As described below, sampler 212 and sampler 214 may operate in two different modes depending on the operation state of self-tuning system 200. When self-tuning system 200 is in state 1 (e.g., when first enabled following a reset), samplers 212 and 214 are configured to, for a "discharge time", described below, fully reset. Once samplers 212 and 214 are reset (ensuring their respective measurement are accurate going-forward), self-tuning system 200 enters state "2" at which time, both sampler 212 and sampler 214, for a "charge time", described below, accumulate the signal output by power supply and detector 208 until sampling of that output signal is completed (the amount of time required is determined, at least in part, by a magnitude of the power supply signal). At that time, as described below, self-tuning circuit 200 moves to a next state "4".

Input power reduction detector 218 is also configured to implement a "time-out" functionality for self-tuning circuit 200. In that case, input power reduction detector 218 is configured to determine a time-out window, the duration of which is proportional to the input power, to wait for the output of input power improvement detector 216. As described herein, the duration of the time-out window is selected to be of greater duration than the time required for input power improvement detector 216 to generate its output signal. If input power improvement detector 216 is unable to generate an output within the time-out window, input power reduction detector 218 generates a time-out indication.

To control the overall operation of self-tuning system 200, controller 220 includes an asynchronous digital circuitry configured to determine the operation of sampler 212 and sampler 214. That circuitry, as described herein, is not a clock driven (thus asynchronous) digital logic but based on the timing events generated by input power improvement detector 216 and input power reduction detector 218. Based on the outputs of input power improvement detector 216 and input power reduction detector 218, a digital portion of controller 220 is configured to implement a capacitor tuning algorithm that determines the configuration of capacitor bank 206.

To summarize the operation of self-tuning system 200, the power level of signals received from detector 208 are monitored over time to determine whether the current configuration of capacitor bank 206 improves antenna coupling. This process is implemented within the analog domain of self-tuning system 200 and does not rely on a digital controller driven by digital clock signals to be performed. Based on that analog monitoring operation, a digital controller 220 is configured to transmit signals to adjust the configuration of capacitor bank 206 to optimize the configuration of antenna 202 to improve power coupling.

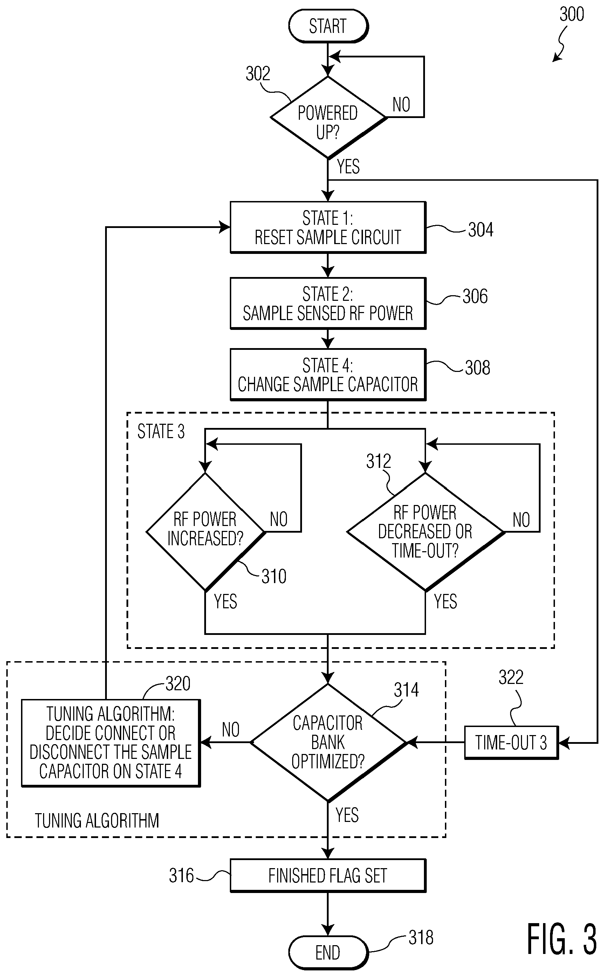

FIG. 3 is a flowchart depicting method 300 that may be implemented by controller 220 to optimize the configuration of capacitor bank 206 and antenna 202 to optimize power coupling from ambient electrical field 204 into antenna 202. FIG. 3 may be best understood while simultaneously viewing FIG. 2.

At block 302, controller 220 determines (e.g., using PMU 210) whether self-tuning circuit 200 is powered up. This determination is based on a magnitude of the power supply signal being received from power supply and detector 208, as described above. If an adequate power supply signal is not being received from power supply and detector 208, the method waits in a loop until an adequate supply for operation of self-tuning system 200 is detected.

If an adequate power supply signal for self-tuning system 200 operation is detected, at block 304 self-tuning system 200 enters a first state in which the signal sampling components of self-tuning system 200 (i.e., sampler 212 and sampler 214) are reset. According to method 300, this may involve controller 220 waiting a period of time (t_{delay1}) to ensure that the sampling block are completely reset before self-tuning system 200 can exit that state.

At the expiration of the reset delay (t_{delay1}), at block 306 controller 220 configures sampler 212 and sampler 214 to measure a magnitude of the signal being received from power supply and detector 208, which derives directly from the electrical energy being coupled onto antenna 202 from ambient electrical field 204. This process can take some time as various sensing capacitors charge (described below), so block 306 is executed for a period of time (t_{delay2}) that is selected to ensure that sampler 212 and sampler 214 have both measured the full magnitude of the signal being received from power supply and detector 208. When the sampling period has elapsed, the method moves onto block 308 in which self-tuning system 200 enters a new state (i.e., state 4) in which controller 220 reconfigures capacitor bank 206 based upon a predetermined capacitor bank modification algorithm according to the measurements generated at block 306.

Method 300 then branches into two parallel paths that performs a comparison to determine whether the samples generated by sampler 212 and sampler 214 at block 306 in a first capacitor bank 206 configuration (i.e., the configuration at block 308) are greater or less than the current power supply signal being generated using the new (second) capacitor bank 206 configured as implemented at block 308.

Specifically, at block 310, controller 220, using a first comparator (e.g., input power improvement detector 216) determines whether the output signal of power supply and detector 208 has increased as a result of the new capacitor bank 206 configuration. At the same time, at block 312, controller 220, using a second comparator (e.g., input power reduction detector 218) determines whether the output signal of power supply and detector 208 has decreased or a particular time-out condition has been met as a result of the new capacitor bank 206 configuration, where the time-out duration may depend, as described herein, as the magnitude of the input signal received from antenna 402.

Using the outputs of the two comparators, as described below, controller 220, at block 314 determines whether the configuration of capacitor bank 206 has been optimized such that the antenna 202 is absorbing a maximum possible amount of energy from ambient electrical field 204 and, consequently, the power supply signal being generated by power supply and detector 208 is at a maximum available value.

In that case, method 300 moves to block 316 in which controller 220 sets a system flag indicating that the self-tuning algorithm is completed and method 300 ends at block 318 with the RFID tag entering normal data-transfer operations.

If, however, at block 314 controller 220 determines that the self-tuning algorithm is not completed, method 300 moves to block 320 in which self-tuning system 200 is put into a new state (i.e., state 4) in which the configuration of capacitor bank 206 is modified (either by increasing or decreasing its capacitance). Specifically, if the outputs of blocks 310 and 312 indicate that the most recent capacitor bank 206 modification results in an increasing in the magnitude of the power supply signal, block 320 involves further modifying the configuration of capacitor bank 206 in the same manner (i.e., by further increasing or decreasing the capacitance of the capacitor bank 206) to potentially increase the magnitude of the power supply signal further. If, however, the outputs of blocks 310 and 312 indicate that the most recent capacitor bank 206 modification resulted in a decrease in the magnitude of the power supply signal, block 320 involves further modifying the configuration of capacitor bank 206 in the opposite manner to potentially improve the magnitude of the power supply signal by tuning antenna 202 in the opposite direction. With capacitor bank 206 so configured, method 300 returns to block 304 and is re-executed to evaluate the new capacitor bank 206 configuration.

In various embodiments, method 300 may include "catch-all" time-out 322 such that in the event the control algorithm of method 300 fails (e.g., due to the digital logic portions being stuck, or other aspects of the control loop hanging) the catch-all time-out 322 can detect that condition and force a system reset.

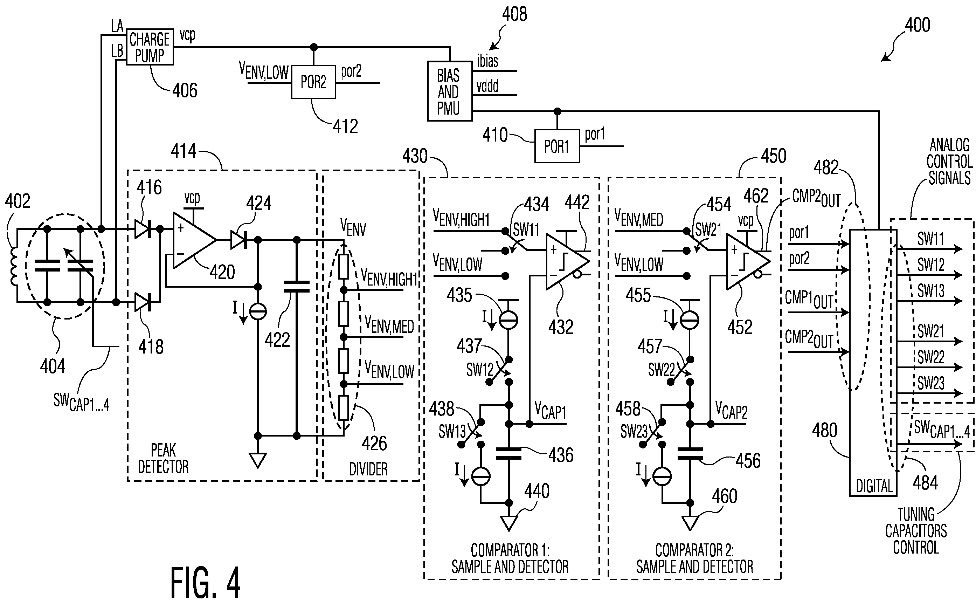

To provide further illustration of the operation of self-tuning system 200, FIG. 4 is a circuit diagram depicting an RFID tag self-tuning circuit 400 configured in accordance with the present disclosure. RFID tag self-tuning circuit 400 may implement the functionality of self-tuning system 200. In RFID tag self-tuning circuit 400, antenna 402 is represented by an inductor. Adjustable capacitors form a variable capacitor bank 404 that can be configured with different capacitances to affect the tuning of antenna 402.

Charge pump 406 is connected across antenna 402 and is configured to accumulate an electric charge based upon the output signal being generated by antenna 402. That accumulated electric charge is output as a voltage (V_{CP}), which is supplied to a start sensor 412 (POR) and the PMU (408) generating the supply voltage for controller (480). The supply voltage for the controller has its own start sensor (POR) 410. Furthermore, VCP supplies voltage to comparators 430 and 450. Sensor 410 is configured to determine whether that output voltage V_{CP} (which is analogous to the power supply signal output by power supply and detector 208 of FIG. 2) is adequate to enable proper operation of RFID tag self-tuning circuit 400. One power-on-reset module 410 is configured to monitor the overall supply signal V_{CP} supplying comparator 430 and comparator 450 and one power-on-reset module 412 is configured to monitor the supply generated from PMU 208 supplying the controller 480.

If the magnitude of the V_{CP} signal exceeds a threshold value (set to the minimum voltage required for proper operation of RFID tag self-tuning circuit 400), two power-on-reset modules 410, 412 generate certain power-on-reset signals that are used to put the state of RFID tag self-tuning circuit 400 into an initial reset before implementing its self-tuning function. Specifically, the power-on-reset values generated by power-on-reset modules 410, 412 are provided as input to controller 480, enabling controller 480 to control the operation of RFID tag self-tuning circuit 400, as detailed below.

RFID tag self-tuning circuit 400 also includes a peak detector circuit 414 configured to determine a magnitude of the envelope signal V_{ENV} derived from the signal being output by antenna 402. In some embodiments, instead of utilizing the signal V_{ENV} output by peak detector circuit 414, the signal output by charge pump 406 (VCP) can be used instead of the envelope signal V_{ENV} as V_{CP} is a signal that is directly proportional to the envelope signal V_{ENV}. Peak detector circuit 414 includes diodes 416, 418 connected across antenna 402. Diodes 416, 418 operate as rectifiers for the AC signal received from antenna 402 to generate a rectified output signal, which is supplied to a first input of operational amplifier 420. A second input of operational amplifier 420 is connected to a first terminal of capacitor 422. The second terminal of capacitor 422 is connected to a ground node and, as such, the second input of operational amplifier 420 receives as an input signal the voltage of capacitor 422. The output of operational amplifier 420 is supplied to diode 424. In this configuration, therefore, the output of diode 424 is a signal equivalent to a magnitude of the envelope of the signal received from antenna 402.

The output of diode 424 is split across a voltage divider 426 comprising several resistances (e.g., provided by resistors, diodes, or other resistive or voltage-dropping components) connected in series between the output of diode 424 and a ground node to generate output voltages V_{ENV,HIGH1} V_{ENV,MED}, and V_{ENV,LOW}. In general, V_{ENV,HIGH} is proportional to the envelope signal V_{ENV} with a small voltage drop to allow for bias of the comparator device 432 of comparator 430. V_{ENV,MED} is proportional to the envelope signal V_{ENV} with a voltage drop and can be used to define the initial voltage (which, in turn, determines the discharge time) of capacitor 456. V_{ENV,LOW} is also proportional to the envelope but with higher voltage drop and is used to define a threshold voltage of capacitor 456 that determines when the capacitor is discharged.

In using these voltages, comparator 430 is configured to first sample the current peak voltage using V_{ENV,HIGH1} (i.e., capacitor 436 is charged to V_{ENV,HIGH1}). In the comparison phase, a later value of V_{ENV,HIGH1} is compared to the current voltage of capacitor 436, which still holds the earlier value of V_{ENV,HIGH1}. If the new value of V_{ENV,HIGH1} is greater than the older value, that indicates a configuration change of variable capacitor bank 404 has improve power coupling. Conversely, within comparator 430, V_{ENV, LOW} is used to discharge capacitor 436 so that capacitor 436 can be put into a known initialization state (e.g., at a voltage equal to V_{ENV, LOW}) before undertaking a new sampling operation.

Within RFID tag self-tuning circuit 400, comparator 450 uses V_{ENV_MED} and V_{ENV_LOW} to generate a time-out that is dependent on the voltage of the signal received from antenna 402. Specifically, capacitor 456, as described herein, is charged to V_{ENV _MED} and then discharged to V_{ENV_LOW}. This requires a certain amount time. If the output of comparator 430 does not toggle within this time period, the output of comparator 450 toggles its output, which is detected and acted upon by controller 480, as described herein.

RFID tag self-tuning circuit 400 includes comparator 430 (e.g., sampler 212 of FIG. 2). Comparator includes comparator device 432. Comparator device 432 includes a first input terminal connected to switch 434. Switch 434 is configured to be selectively connected to terminals that receive the various voltage values V_{ENV,HIGH1}, V_{ENV,MED}, and V_{ENV,LOW} output by peak detector circuit 414. The second input terminal of comparator device 432 receives as an input the voltage of capacitor 436. Switch 438 is connected across capacitor 436. During normal operations, switch 438 is maintained in an open position such that the voltage of capacitor 436 is provided as an input to the second terminal of comparator device 432. If, however, switch 438 is closed, capacitor 436 discharges its stored voltage into ground node 440. A current source 435 is connected to capacitor through a switch 437. When switch 437 is closed, current source 435 operates to charge capacitor 436.

In this configuration, comparator device 432 is configured to output at output terminal 442 a high value when the input received at the first input terminal is greater than the input received at the second input terminal and a low value when the input received at the first input terminal is less than the input received at the second input terminal from capacitor 436. Comparator device 432

RFID tag self-tuning circuit 400 includes comparator 450 (e.g., sampler 214 of FIG. 2). Comparator 450 includes comparator device 452. Comparator device 452 includes a first input terminal connected to switch 454. Switch 454 is configured to be selectively connected to terminals that receive the various voltage values V_{ENV,MED}, and V_{ENV,LOW} output by peak detector circuit 414. The second input terminal of comparator device 452 receives as an input the voltage of capacitor 456. Switch 458 is connected across capacitor 456. During normal operations, switch 458 is maintained in an open position such that the voltage of capacitor 456 is provided as an input to the second terminal of comparator device 452. If, however, switch 458 is closed, capacitor 456 discharges its stored voltage into ground node 460. A current source 455 is connected to capacitor through a switch 457. When switch 457 is closed, current source 455 operates to charge capacitor 456.

In this configuration, comparator device 452 is configured to output at output terminal 462 a high value when the input received at the first input terminal is greater than the input received at the second input terminal and a low value when the input received at the first input terminal is less than the input received at the second input terminal from capacitor 456.

Controller 480 includes input terminals configured to receive various signals from other components in RFID tag self-tuning circuit 400. Specifically, controller 480 includes input terminals 482 configured to receive each of the power-on-reset signals generated by power-on-reset module 410 and power-on-reset module 412, and the two output signals output by each of comparator device 432 and comparator device 452. Using those input signals, controller 480 is configured to implement a method for controlling the operation of RFID tag self-tuning circuit 400. Controller 480 controls the operation of RFID tag self-tuning circuit 400 by generating output signals at output terminals 484 to control the configuration of various components of RFID tag self-tuning circuit 400. Specifically, the output terminals 484 output control signals that control the operation of switches 434 (i.e., SW11), 437 (i.e., SW12), 438 (i.e., SW13), 454 (i.e., SW21), 455 (i.e., SW22), 458 (i.e., SW23), and the configuration of variable capacitor bank 404 (i.e., SW_{CAP}).

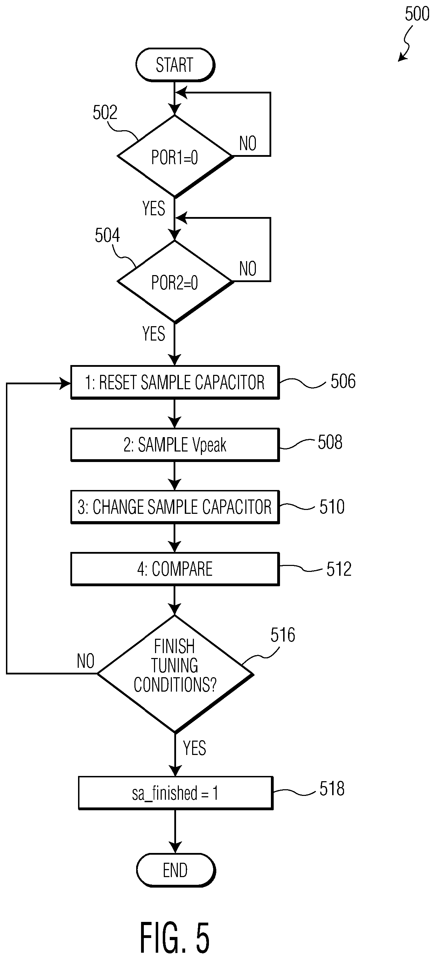

FIG. 5 is a flowchart depicting method 500 that may be implemented by controller 480 of RFID tag self-tuning circuit 400 to implement a self-tuning algorithm to determine an optimal configuration of antenna 402 and variable capacitor bank 404 of RFID tag self-tuning circuit 400. FIGs 5-8 may be best understood while simultaneously viewing FIG. 4.

At blocks 502 and 504, controller 480 monitors, at inputs 482, the power-on-reset signals from power-on-reset module 410 and power-on-reset module 412. If both reset signal indicate that adequate energy is being supplied from antenna 402 to enable operation of RFID tag self-tuning circuit 400, the self-tuning algorithm can be executed.

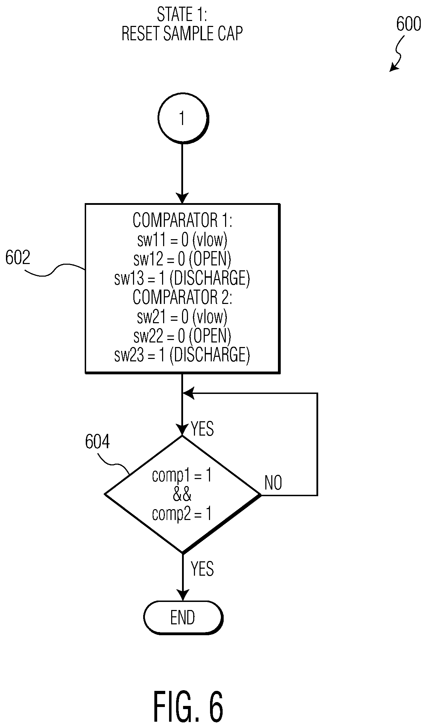

Method 500 then moves to block 506 to put RFID tag self-tuning circuit 400 into state 1, as described above, that initiates a reset of the signal sampling capacitors (i.e., capacitors 436 and 456) of RFID tag self-tuning circuit 400. To illustrate, FIG. 6 is a flow chart depicting an example method 600 implemented by controller 480 to perform this initiation process. At block 602, controller 480, via its various output signals 484 configures components of 400 in the following manner. In comparator 430, controller 480 operates switch 434 so that the voltage V_{ENV,LOW} is connected to the first input terminal of comparator device 432. Controller 480 opens switch 437 (disconnecting capacitor 436 from current source 435). Controller 480 closes switch 438 thereby discharging capacitor 436 into ground node 440. In a similar manner, in comparator 450, controller 480 operates switch 454 so that the voltage V_{ENV,LOW} is connected to the first input terminal of comparator device 452. Controller 480 opens switch 457 (disconnecting capacitor 456 from current source 455). Controller 480 closes switch 458 thereby discharging capacitor 456 into ground node 460. At block 604, a control loop is implemented that will maintain switches 438, 437, 458, and 457 in this condition until the outputs of both comparator device 432 and output terminal 462 go to a high value, indicating both sensing capacitors capacitor 436 and 456 have fully discharged.

Once both capacitor 436 and 456 are discharged (and the outputs of comparator 430 and comparator 450 have gone to high values indicating that the voltage across each capacitor 436, 456 is less than V_{ENV,LOW}, comparator 430 and comparator 450 are reset and method 600 ends.

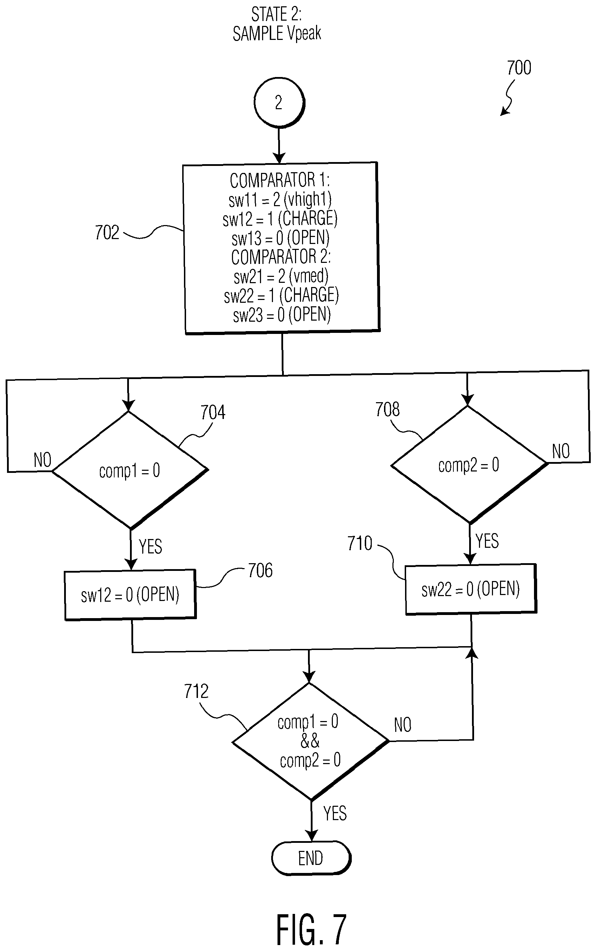

Returning to FIG. 5, with comparator 430 and comparator 450 reset, at block 508 controller 480 puts RFID tag self-tuning circuit 400 into state 2 in which the magnitude of the signal being received from antenna 402 in its current configuration (i.e., with variable capacitor bank 404 set to a particular capacitor value) is measured. FIG. 7 is a flow chart depicting an example method 700 implemented by controller 480 to perform this signal process. At block 702, controller 480, via its various output signals 484, configures components of 400 in the following manner. In comparator 430, switch 434 is configured to connect to the input terminal set at the voltage V_{ENV,HIGH1} so that voltage is provided at the first input of comparator device 432. Switch 437 is closed such that capacitor 436 begins being charged by current source 435. The output of comparator device 432 will be a high value until the voltage stored by capacitor 436 is charged to an amount that equals the voltage V_{ENV,HIGH1}, at which time the output of comparator device 432 will become a low value. When switch 437 closed, switch 438 is opened to prevent discharge from capacitor 436 into ground node 440.

In comparator 450, switch 454 is configured to connect to the input terminal set at the voltage V_{ENV,MED} so that voltage is provided at the first input of comparator device 452.

Switch 457 is closed such that capacitor 456 begins being charged by current source 455. The output of comparator device 452 will be a high value until the voltage stored by capacitor 456 equals the voltage V_{ENV,MED}, at which time the output of comparator device 452 will become a low value. When switch 457 is closed, switch 458 is opened to prevent discharge from capacitor 456 into ground node 460.

In this configuration, capacitor 436 is charged to or takes a sample of the voltage V_{ENV,HIGH1}, at which time the output of comparator device 432 becomes a low value. At the same time, capacitor 456 is being charged to or takes a sample of the voltage V_{ENV,MED}, at which time the output of comparator device 452 becomes a low value.

In method 700, at block 704, controller 480 monitors the output of comparator 430 (i.e., the output of comparator device 432 at output terminal 442) to detect when its output has switched to a low value (indicating that capacitor 436 has charged to the voltage V_{ENV,HIGH1}), at that time, at block 706, switch 437 is opened to prevent further changing of capacitor 436 such that the voltage of capacitor 436 is held at V_{ENV,HIGH1}.

In a separate method flow at block 708 controller 480 monitors the output of comparator 450 (i.e., the output of comparator device 452 at output terminal 462) to detect when its output has switched to a low value (indicating that capacitor 456 has charged to the desired voltage V_{ENV,MED}), at that time, at block 710, switch 457 is opened to prevent further changing of capacitor 456 such that the voltage of capacitor 456 is held at V_{ENV,MED}.

After the outputs of both comparators 430, 450 have switched to low values (confirmed by controller 480 at step 712) method 700 ends.

Returning to FIG. 5, after completing the sampling block 508 to capture the current voltage of V_{ENV,HIGH1} in capacitor 436 and the voltage of V_{ENV,MED} in capacitor 456, controller 480 is configured to, at block 510 and using control signals generated at output terminals 484, modify the configuration of variable capacitor bank 404 (e.g., by removing one capacitor from the bank, thereby reducing the capacitance of variable capacitor bank 404 by a discrete amount, though other modification algorithms, such as one in which a capacitor is initially added to the bank, may be utilized). In a first execution of block 510, the configuration of variable capacitor bank 404 either increases or decreases the capacitance of variable capacitor bank 404 in accordance with a system variable <sign>. If <sign> is positive, the capacitance is increased by one step. If <sign> is negative the capacitance is reduced. The initial value of the variable <sign> can be according to a predetermined process. As discussed below, as the self-tuning algorithm progresses, the value of <sign> may be modified for future executions of block 510 to refine the configuration of variable capacitor bank 404.

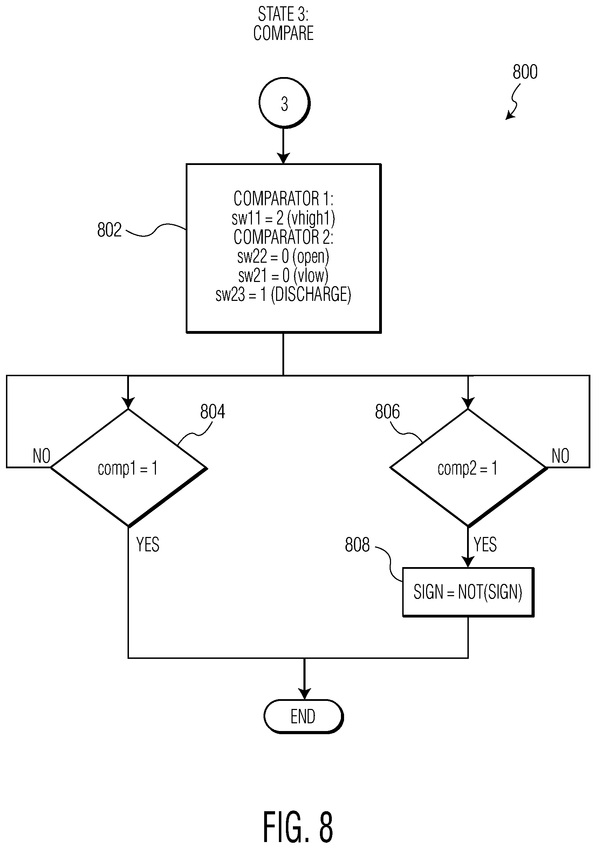

At block 512, a comparison step is performed in which controller 480 determines whether the new configuration of variable capacitor bank 404 resulting from block 510 has improved the tuning of antenna 402 such that the amount of energy being coupled into antenna 402 has increased. FIG. 8 is a flow chart depicting an example method 800 implemented by controller 480 to perform this comparison step. At block 802, controller 480, via its various output signals 484, configures components of 400 in the following manner. In comparator 430, switch 434 is configured to connect to the terminal at the voltage V_{ENV,HIGH1}. The voltage of V_{ENV,HIGH1} is determined by the envelope of the signal being received from antenna 402 (described above) with variable capacitor bank 404 in its new configuration and so if the new configuration of variable capacitor bank 404 has improved antenna 402 coupling, V_{ENV,HIGH1} may have increased as compared to its value earlier that was sampled in the process of executing block 508, above. In comparator 450, switch 454 is connected to the terminal at the voltage V_{ENV,LOW}. Switch 458 is closed causing capacitor 456 to begin discharging (an operation that can be controlled by a current sink) into ground node 460 and switch 457 is opened (at the same time as switch 458 is closed).

In this configuration, if the new configuration of variable capacitor bank 404 has improved antenna 402 coupling, such that the current value of V_{ENV,HIGH1} is greater than the value of V_{ENV,HIGH1} during the sampling step (block 508 of FIG. 5), the output of comparator device 432 will go to a high value, indicating that the new configuration of variable capacitor bank 404 is an improvement. If that is the case, at block 804, controller 480 determines that the output of 430 (i.e., at output terminal 442 of comparator device 432) has gone to a high value and method 800 ends. In this state, the value of <sign> is unchanged - because the prior modification to the configuration of the variable capacitor bank 404 improved coupling, coupling could be further improved by additional changes to the configuration of the variable capacitor bank 404 in the same "direction." As such any change to the configuration of variable capacitor bank 404 in future iterations will modify the capacitance of variable capacitor bank 404 in the same direction as the change that was made before method 800 was executed. In short, the prior configuration change of variable capacitor bank 404 improved antenna 402 coupling so further changes in the same direction may further improve that coupling.

If, however, the new configuration of variable capacitor bank 404 has not improved antenna 402 coupling, such that the current value of V_{ENV,HIGH1} is less than the value of V_{ENV,HIGH1} during the sampling step (block 508 of FIG. 5) and stored on capacitor 436, the output of comparator 430 will stay low and block 804 will not be completed. In that case, comparator 450 operates as an analog time-out detector. In the configuration of 450, capacitor 456 will gradually discharge into ground node 460 until the voltage stored on capacitor 456 falls below the minimum value V_{ENV,LOW}. Once that discharge is complete, the output of comparator 450 will switch to a high value, which is detected at block 806. This condition indicates that the most recent change to the configuration of variable capacitor bank 404 did not improve antenna 402 coupling. Consequently, the value of <sign> is inverted at block 808 so that any further changes to the configuration of variable capacitor bank 404 occur in the opposite direction, and the method ends.

Returning to FIG. 5, at block 516 controller determines whether the conditions have been met to exit the self-tuning operation. This may involve determining whether block 510 has been executed a threshold number of times, whether the capacitor bank has reached a configuration that is equivalent to either a minimum or maximum capacitance, or whether the self-tuning algorithm has timed out (e.g., has timed-out more than 1 time in a row or sequentially).

When the finish tuning conditions have been met at block 516, a variable sa_finished is set to a high value of '1' at block 518 to indicate self-tuning is complete, the method ends, and the current configuration of variable capacitor bank 404 is utilized for further RF tag operations.

Although not shown in FIG. 5, additional stop criteria may exist. For example, if a system failure occurs, or any of the system voltages (e.g., V_{CP}, or V_{ENV}-derived voltages) fall below particular threshold values, the method may exit prematurely even if the self-tuning process is not complete.

If, however, at block 516 it is determined that the conditions to exit the self-tuning operation are not met, the method returns to block 506 to again perform the reset, sampling, and variable capacitor bank 404 adjustment of blocks 506, 508, and 510. In these future iterations, the capacitance of variable capacitor bank 404 is adjusted according to the <sign> value that was set in method 800.

In some aspects, the techniques described herein relate to a radio frequency identification (RFID) tag, including: an antenna configured to receive an input signal; a variable capacitor bank electrically coupled to the antenna; and a self-tuning circuit coupled with the antenna, wherein the self-tuning circuit is configured to modify a capacitance of the variable capacitor bank to optimize a signal strength of the input signal according to a self-tuning algorithm, wherein the self-tuning circuit does not include a clock source and the self-tuning circuit includes: a first comparator, including: a first capacitor configured to store a first voltage indicative of a first magnitude of the input signal when the variable capacitor bank is in a first configuration, and a first comparator device having a first input terminal and a second input terminal, wherein the first input terminal is configured to receive a second voltage indicative of a second magnitude of the input signal when the variable capacitor bank is in a second configuration and the second input terminal is configured to receive the first voltage from the first capacitor, wherein the first comparator device is configured to generate a first output signal based on a difference between the first voltage and the second voltage; and a controller configured to determine, using the first output signal of the first comparator device, that the first configuration of the variable capacitor bank results in an optimized configuration of the variable capacitor bank compared to the second configuration and to configure the variable capacitor bank in the first configuration.

**In** some aspects, the techniques described herein relate to a RFID tag, further including: a second comparator, including: a second capacitor, and a second comparator device having a first input terminal and a second input terminal, wherein the first input terminal is configured to receive an input signal and the second input terminal is configured to connect to the second capacitor.

**In** some aspects, the techniques described herein relate to a RFID tag, wherein the controller is configured to: cause the second capacitor to store the first voltage indicative of the first magnitude of the input signal when the variable capacitor bank is in the first configuration; apply a threshold voltage to the first input terminal of the second comparator device, wherein the threshold voltage in a minimum voltage value of the self-tuning circuit; and connect the second capacitor to a ground node to cause the second capacitor to discharge, wherein when a voltage of the second capacitor is greater than the threshold voltage, the second comparator device generates a low output value and when the voltage of the second capacitor is less than the threshold voltage, the second comparator device generates a high output value.

**In** some aspects, the techniques described herein relate to a RFID tag, wherein the controller is configured to: detect that an output of the second comparator device has transitioned from the low output value of to the high output value; and cause the self-tuning circuit to terminate execution of the self-tuning algorithm.

**In** some aspects, the techniques described herein relate to a RFID tag, wherein the controller is configured to reset the self-tuning circuit by discharging the first capacitor into the ground node and discharging the second capacitor into the ground node before executing the self-tuning algorithm.

In some aspects, the techniques described herein relate to a RFID tag, wherein the first voltage indicative of the first magnitude of the input signal and the threshold voltage are generated by a voltage divider electrically connected to the antenna.

In some aspects, the techniques described herein relate to a RFID tag, wherein a rectifier is connected between the voltage divider and the antenna.

In some aspects, the techniques described herein relate to a RFID tag, wherein the first comparator is configured to generate the first output signal without receiving or using an oscillating clock signal.

In some aspects, the techniques described herein relate to a device, including: a first comparator, including: a first capacitor configured to store a first voltage indicative of a first magnitude of an input signal when a variable capacitor bank coupled to an antenna is in a first configuration, and a first comparator device having a first input terminal and a second input terminal, wherein the first input terminal is configured to receive a second voltage indicative of a second magnitude of the input signal when the variable capacitor bank is in a second configuration and the second input terminal is configured to receive the first voltage from the first capacitor, wherein the first comparator device is configured to generate a first output signal based on a difference between the first voltage and the second voltage; and a controller configured to determine a configuration of a variable capacitor bank using the first output signal of the first comparator device.

In some aspects, the techniques described herein relate to a device, further including: a second comparator, including: a second capacitor, and a second comparator device having a first input terminal and a second input terminal, wherein the first input terminal is configured to receive an input signal and the second input terminal is configured to connect to the second capacitor.

In some aspects, the techniques described herein relate to a device, wherein the controller is configured to: cause the second capacitor to store the first voltage indicative of the first magnitude of the input signal when the variable capacitor bank is in the first configuration; apply a threshold voltage to the first input terminal of the second comparator device, wherein the threshold voltage in a minimum voltage value of the device; and connect the second capacitor to a ground node to cause the second capacitor to discharge, wherein when a voltage of the second capacitor is greater than the threshold voltage, the second comparator device generates a low output value and when the voltage of the second capacitor is less than the threshold voltage, the second comparator device generates a high output value.

**In** some aspects, the techniques described herein relate to a device, wherein the first voltage indicative of the first magnitude of the input signal and the threshold voltage are generated by a voltage divider electrically connected to the antenna.

**In** some aspects, the techniques described herein relate to a device, wherein a rectifier is connected between the voltage divider and the antenna.

**In** some aspects, the techniques described herein relate to a device, wherein the first comparator is configured to generate the first output signal without receiving or using an oscillating clock signal.

**In** some aspects, the techniques described herein relate to a method of executing a self-tuning algorithm for a radio frequency identification tag, including: storing a first voltage indicative of a first magnitude of an input signal to an antenna in a first capacitor when a variable capacitor bank coupled to the antenna is in a first configuration; providing a second voltage indicative of a second magnitude of the input signal when the variable capacitor bank is in a second configuration to a first input terminal of a first comparator device; providing the first voltage from the first capacitor to a second input terminal of the first comparator device, wherein the first comparator device is configured to generate a first output signal based on a difference between the first voltage and the second voltage; determining, using the first output signal of the first comparator device, that the first configuration of the variable capacitor bank results in an optimized configuration of the variable capacitor bank compared to the second configuration; and configuring the variable capacitor bank in the first configuration.

**In** some aspects, the techniques described herein relate to a method, further including providing a second comparator having a first input terminal configured to receive an input signal, wherein a second input terminal of the second comparator is connected to a second capacitor.

**In** some aspects, the techniques described herein relate to a method, further including: causing the second capacitor to store the first voltage indicative of the first magnitude of the input signal when the variable capacitor bank is in the first configuration; applying a threshold voltage to the first input terminal of the second comparator device, wherein the threshold voltage in a minimum voltage value; and connecting the second capacitor to a ground node to cause the second capacitor to discharge, wherein when a voltage of the second capacitor is greater than the threshold voltage, the second comparator device generates a low output value and when the voltage of the second capacitor is less than the threshold voltage, the second comparator device generates a high output value.

In some aspects, the techniques described herein relate to a method, further including: detecting that an output of the second comparator device has transitioned from the low output value of to the high output value; and terminating the self-tuning algorithm.

In some aspects, the techniques described herein relate to a method, further including generating the first voltage indicative of the first magnitude of the input signal and the threshold voltage using a voltage divider.

In some aspects, the techniques described herein relate to a method, further generating the first output signal without receiving or using an oscillating clock signal.

As will be appreciated by one skilled in the art, aspects of the present disclosure may be embodied as a system, process, method, and/or program product. Accordingly, various aspects of the present disclosure may take the form of an entirely hardware embodiment, an entirely software embodiment (including firmware, resident software, microcode, etc.), or embodiments combining software and hardware aspects, which may generally be referred to herein as a "circuit," "circuitry," "module," or "system." Furthermore, aspects of the present disclosure may take the form of a program product embodied in one or more computer readable storage medium(s) having computer readable program code embodied thereon. (However, any combination of one or more computer readable medium(s) may be utilized. The computer readable medium may be a computer readable signal medium or a computer readable storage medium.)

A computer readable storage medium may be, for example, but not limited to, an electronic, magnetic, optical, electromagnetic, infrared, biologic, atomic, or semiconductor system, apparatus, controller, or device, or any suitable combination of the foregoing, wherein the computer readable storage medium is not a transitory signal per se.

A computer readable signal medium may include a propagated data signal with computer readable program code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, controller, or device.

The block diagrams in the figures illustrate architecture, functionality, and operation of possible implementations of circuitry, systems, methods, processes, and program products according to various embodiments of the present disclosure. In this regard, certain blocks in the block diagrams may represent a module, segment, or portion of code, which includes one or more executable program instructions for implementing the specified logical function(s). It should also be noted that, in some implementations, the functions noted in the blocks may occur out of the order noted in the figures. For example, two blocks shown in succession may, in fact, be executed substantially concurrently, or the blocks may sometimes be executed in the reverse order, depending upon the functionality involved.

These program instructions may be provided to one or more processors and/or controller(s) of a general-purpose computer, special purpose computer, or other programmable data processing apparatus (e.g., controller) to produce a machine, such that the instructions, which execute via the processor(s) of the computer or other programmable data processing apparatus, create circuitry or means for implementing the functions/acts specified in the block diagram block or blocks.

The preceding detailed description is merely illustrative in nature and is not intended to limit the embodiments of the subject matter or the application and uses of such embodiments.

As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A radio frequency identification (RFID) tag, comprising:
an antenna configured to receive an input signal;
a variable capacitor bank electrically coupled to the antenna; and
a self-tuning circuit coupled with the antenna, wherein the self-tuning circuit is configured to modify a capacitance of the variable capacitor bank to optimize a signal strength of the input signal according to a self-tuning algorithm, wherein the self-tuning circuit does not include a clock source and the self-tuning circuit includes:
a first comparator, including:
a first capacitor configured to store a first voltage indicative of a first magnitude of the input signal when the variable capacitor bank is in a first configuration, and
a first comparator device having a first input terminal and a second input terminal, wherein the first input terminal is configured to receive a second voltage indicative of a second magnitude of the input signal when the variable capacitor bank is in a second configuration and the second input terminal is configured to receive the first voltage from the first capacitor, wherein the first comparator device is configured to generate a first output signal based on a difference between the first voltage and the second voltage; and
a controller configured to determine, using the first output signal of the first comparator device, that the first configuration of the variable capacitor bank results in an optimized configuration of the variable capacitor bank compared to the second configuration and to configure the variable capacitor bank in the first configuration.

2. The RFID tag of claim 1, further comprising:
a second comparator, including:
a second capacitor, and
a second comparator device having a first input terminal and a second input terminal, wherein the first input terminal is configured to receive an input signal and the second input terminal is configured to connect to the second capacitor.

3. The **RFID** tag of claim 2, wherein the controller is configured to:
cause the second capacitor to store the first voltage indicative of the first magnitude of the input signal when the variable capacitor bank is in the first configuration;
apply a threshold voltage to the first input terminal of the second comparator device, wherein the threshold voltage in a minimum voltage value of the self-tuning circuit; and
connect the second capacitor to a ground node to cause the second capacitor to discharge, wherein when a voltage of the second capacitor is greater than the threshold voltage, the second comparator device generates a low output value and when the voltage of the second capacitor is less than the threshold voltage, the second comparator device generates a high output value.

4. The RFID tag of claim 3, wherein the controller is configured to:
detect that an output of the second comparator device has transitioned from the low output value of to the high output value; and
cause the self-tuning circuit to terminate execution of the self-tuning algorithm.

5. The RFID tag of claim 4, wherein the controller is configured to reset the self-tuning circuit by discharging the first capacitor into the ground node and discharging the second capacitor into the ground node before executing the self-tuning algorithm.

6. The RFID tag of any one of claims 3 to 5, wherein the first voltage indicative of the first magnitude of the input signal and the threshold voltage are generated by a voltage divider electrically connected to the antenna.

7. The RFID tag of claim 6, wherein a rectifier is connected between the voltage divider and the antenna.

8. The RFID tag of any preceding claim, wherein the first comparator is configured to generate the first output signal without receiving or using an oscillating clock signal.

9. A method of executing a self-tuning algorithm for a radio frequency identification tag, comprising:
storing a first voltage indicative of a first magnitude of an input signal to an antenna in a first capacitor when a variable capacitor bank coupled to the antenna is in a first configuration;
providing a second voltage indicative of a second magnitude of the input signal when the variable capacitor bank is in a second configuration to a first input terminal of a first comparator device;
providing the first voltage from the first capacitor to a second input terminal of the first comparator device, wherein the first comparator device is configured to generate a first output signal based on a difference between the first voltage and the second voltage;
determining, using the first output signal of the first comparator device, that the first configuration of the variable capacitor bank results in an optimized configuration of the variable capacitor bank compared to the second configuration; and
configuring the variable capacitor bank in the first configuration.

10. The method of claim 9, further comprising providing a second comparator having a first input terminal configured to receive an input signal, wherein a second input terminal of the second comparator is connected to a second capacitor.

11. The method of claim 10, further comprising:
causing the second capacitor to store the first voltage indicative of the first magnitude of the input signal when the variable capacitor bank is in the first configuration;
applying a threshold voltage to the first input terminal of the second comparator device, wherein the threshold voltage in a minimum voltage value; and
connecting the second capacitor to a ground node to cause the second capacitor to discharge, wherein when a voltage of the second capacitor is greater than the threshold voltage, the second comparator device generates a low output value and when the voltage of the second capacitor is less than the threshold voltage, the second comparator device generates a high output value.

12. The method of claim 11, further comprising:
detecting that an output of the second comparator device has transitioned from the low output value of to the high output value; and
terminating the self-tuning algorithm.

13. The method of claim 12, further comprising generating the first voltage indicative of the first magnitude of the input signal and the threshold voltage using a voltage divider.

14. The method of any one of claims 9 to 13, further generating the first output signal without receiving or using an oscillating clock signal.
